# FASCICULE DE BREVET EUROPEEN

(11) **EP 0 977 269 B1**
(45) Date de publication et mention de la délivrance du brevet: **30.08.2006**
(21) Numéro de dépôt: 99410090.7
(22) Date de dépôt: 26.07.1999
(51) Int. Cl.: H01L 27/146, H01L 31/0216

(54) **Capteur d'image à réseau de photodiodes**
Bildsensor mit Photodiodenanordnung
Imager having an array of photodiodes

(30) Priorité: 28.07.1998 FR 9809801
(43) Date de publication de la demande: 02.02.2000
(73) Titulaire: STMicroelectronics S.A., 92120 Montrouge (FR)
(72) Inventeur: Descure, Pierrick, 38330 Saint Ismier (FR)
(74) Mandataire: de Beaumont, Michel

(56) Documents cités:
- EP-A- 0 152 353
- EP-A- 0 223 136
- EP-A- 0 509 820
- US-A- 4 242 694
- US-A- 5 502 488
- PATENT ABSTRACTS OF JAPAN vol. 009, no. 262 (P-398), 19 octobre 1985 (1985-10-19) -& JP 60 111225 A (MATSUSHITA DENKI SANGYO KK), 17 juin 1985 (1985-06-17)

## Description

La présente invention concerne le domaine des capteurs d'image, utilisables par exemple dans les caméras vidéo.

Parmi les diverses techniques pour transformer une image projetée sur une cible en données électriques, on utilise notamment des cibles constituées d'un substrat semiconducteur portant un réseau de photodiodes. Les diodes sont initialement polarisées en inverse et chargées capacitivement. En l'absence de lumière, elles conservent leur charge et, quand elles sont éclairées, elles se déchargent. On peut ainsi différencier un élément d'image ou pixel lumineux d'un pixel sombre et reconstituer une image sous forme de matrice de données correspondant aux charges électriques de chacun des pixels.

En outre, il est connu de constituer cette matrice de sorte que l'ensemble de pixels soit divisé en trois sous-réseaux correspondant à chacune de trois couleurs (couramment, rouge, vert et bleu). Pour cela, chacun des pixels, c'est-à-dire chacune des diodes, est revêtu d'un filtre de couleur. Il est connu d'utiliser comme filtre de couleur un filtre interférentiel. On a également proposé des filtres interférentiels constitués de matériaux compatibles avec les filières habituelles de fabrication de circuits intégrés de type MOS. Ainsi, un filtre interférentiel peut être constitué d'une couche d'oxyde de silicium revêtue d'une couche de silicium polycristallin, elle-même revêtue d'une couche de nitrure de silicium. En fait, il importe que les matériaux successifs aient alternativement des indices optiques bas et haut.

Le document EP-A-0 223 136 décrit un système de filtres pour un capteur d'image avec plusieurs couches conductrices et isolantes.

Dans de telles structures, la capacité de stockage de chaque pixel est liée à la dimension de ce pixel et plus particulièrement à la dimension de la jonction de la diode associée.

Un objet de la présente invention est d'accroître cette capacité de stockage sans augmenter la dimension d'une cellule élémentaire du capteur et sans compliquer sa fabrication.

Pour atteindre cet objet ainsi que d'autres, la présente invention prévoit un réseau de photodiodes constitué de régions d'un deuxième type de conductivité formées dans une région semiconductrice d'un premier type de conductivité, divisé en trois sous-réseaux imbriqués, toutes les photodiodes d'un même sous-réseau étant revêtu d'un même filtre interférentiel comprenant au moins une couche isolante d'épaisseur déterminée revêtue d'au moins une couche conductrice. Les couches conductrices sont électriquement connectées à la région semiconductrice d'un premier type de conductivité.

Selon un mode de réalisation de la présente invention, le substrat semiconducteur est un substrat de silicium monocristallin, et le filtre interférentiel comporte une couche d'oxyde de silicium formée au-dessus du substrat et une couche de silicium polycristallin conducteur formée au-dessus de la couche d'oxyde de silicium.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1A représente une vue en coupe schématique d'un pixel d'un réseau de photodiodes selon la présente invention ;
la figure 1B représente le schéma équivalent du pixel de la figure 1A ;
les figures 2A, 2B, 2C illustrent des étapes successives d'un procédé de réalisation d'une couche d'un filtre interférentiel utilisé selon la présente invention ;
la figure 3 représente sous forme de schéma un capteur d'image constitué d'une matrice de photodiodes selon la présente invention et
la figure 4 représente un exemple de réalisation d'un pixel d'un capteur d'image selon la figure 3.

On notera que, comme cela est usuel dans le domaine de la représentation des composants semiconducteurs, les diverses figures ne sont pas tracées à l'échelle mais que les dimensions de leurs divers éléments ont été arbitrairement modifiées pour faciliter la lisibilité et simplifier le tracé des dessins.

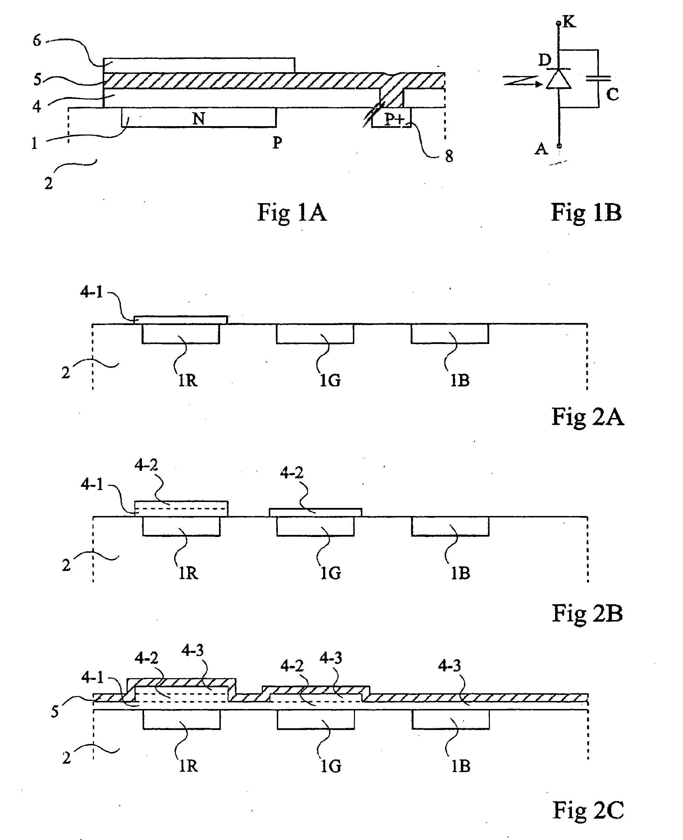

La figure 1A représente une vue en coupe d'une photodiode associée à un filtre interférentiel selon la présente invention. Cette photodiode est constituée d'une région semiconductrice 1 de type N formée dans un substrat semiconducteur 2 de type P. On considérera ici que le substrat est en silicium monocristallin. Au-dessus de la région 1 est formé un dépôt multicouche constituant un filtre interférentiel et comprenant par exemple une couche d'oxyde de silicium 4, une couche de silicium polycristallin 5 et une couche de nitrure de silicium 6. Pour des rayonnements optiques dans le domaine du visible, le silicium monocristallin et le silicium polycristallin ont un indice de réfraction élevé, de l'ordre de 4, tandis que l'oxyde de silicium et le nitrure de silicium ont des indices faibles, de l'ordre de 1,5. De façon connue, l'épaisseur des diverses couches doit être ajustée pour assurer un effet anti-reflet et un effet de filtrage adaptés à une longueur d'onde particulière. Par exemple, si les couches 5 et 6 ont des épaisseurs respectives de 20 et 50 nm, on forme un filtre pour le bleu en choisissant pour la couche d'oxyde 4 une épaisseur de l'ordre de 150 nm, un filtre pour le vert avec une épaisseur de l'ordre de 190 nm et un filtre pour le rouge avec une épaisseur de l'ordre de 230 nm.

Selon la présente invention, la couche de silicium polycristallin 5 n'est pas laissée flottante mais mise au même potentiel que le substrat 2. Ceci est schématisé dans la figure par un contact entre la couche 5 et une région 8 fortement dopée de type P du substrat 2. La couche de silicium polycristallin 5 est suffisamment dopée pour être bien conductrice ; elle peut aussi être revêtue d'une couche métallique (de l'aluminium) ou siliciurée, en dehors des régions où elle est utile à la réalisation d'un filtre.

Du fait de la liaison entre la couche 5 et le substrat 2, la structure correspond au schéma équivalent représenté en figure 1B. On suppose que la région de cathode 1 de la photodiode D est reliée à une borne K non représentée en figure 1A et que l'anode de la photodiode est connectée à une borne A, couramment reliée à la masse. La présence de la couche conductrice 5 reliée au substrat équivaut à l'existence d'un condensateur C disposé en parallèle sur la diode. La première "plaque" du condensateur est constituée par la couche 5 reliée au substrat, c'est-à-dire à l'anode de la diode. La deuxième "plaque" du condensateur correspond à la région de cathode 1 de la diode.

On augmente ainsi la capacité équivalente de chaque diode, c'est-à-dire que l'on augmente la capacité de stockage de chaque photoélément et donc la dynamique des signaux électriques résultant d'un éclairement. On améliore également la linéarité de la caractéristique charge/tension du photoélément par l'ajout d'une capacité constante à la capacité de la jonction de la diode qui, elle, est variable avec la tension appliquée.

Les figures 2A à 2C illustrent un exemple de procédé pour former des couches d'oxyde d'épaisseur différentes sur trois groupes de régions de cathode 1R, 1G, 1B respectivement sensibles au rouge, au vert et au bleu.

Dans une première étape illustrée en figure 2A, on dépose une première couche d'oxyde de silicium 4-1 que l'on grave pour la maintenir en place seulement au-dessus des régions 1R.

Dans une deuxième étape illustrée en figure 2B, on dépose une deuxième couche d'oxyde de silicium 4-2 que l'on grave pour la laisser en place seulement au-dessus des régions 1R et 1G.

Dans une troisième étape illustrée en figure 2C, on dépose une troisième couche d'oxyde de silicium 4-3 qu'on laisse en place. Après quoi, on dépose une couche de silicium polycristallin 5 et éventuellement, comme cela a été décrit précédemment, une couche de nitrure de silicium. Ensuite, la structure est convenablement gravée pour permettre la réalisation de contacts en des emplacements choisis.

L'épaisseur de la couche 4-3, dans le cas de l'exemple donné précédemment est de 150 nm, et les épaisseurs des couches 4-1 et 4-2 sont de 40 nm de sorte que l'on trouve au-dessus des régions 1R, 1G et 1B des couches d'oxyde ayant des épaisseurs respectives de 230, 190 et 150 nm.

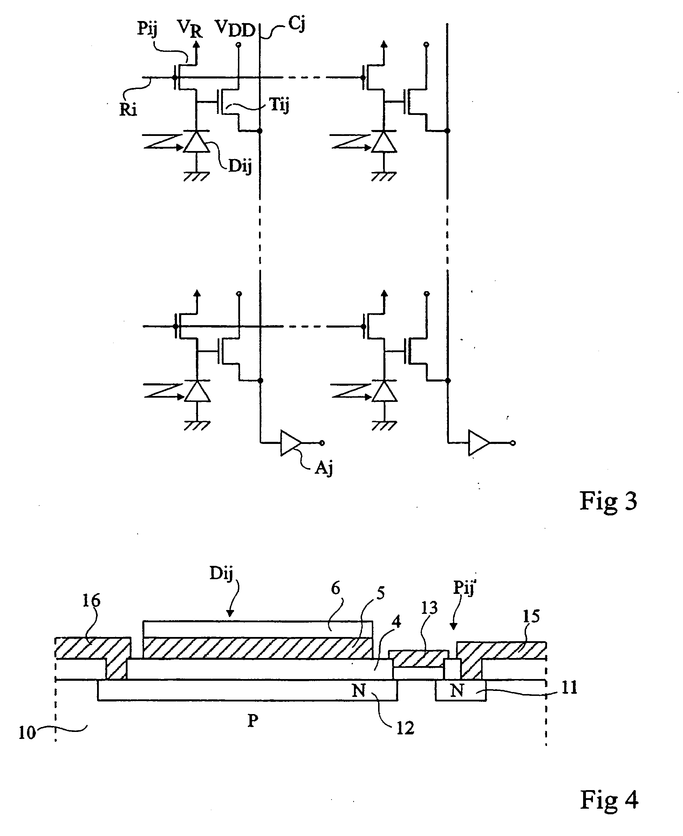

La figure 3 représente à titre d'exemple, de façon partielle, et sous forme de circuit la structure classique d'un réseau de photodiodes destiné à former un capteur d'image. Chaque photodiode Dij est reliée par son anode à la masse et par sa cathode à la source d'un transistor de précharge Pij dont le drain est relié à une tension de référence VR et dont la grille est reliée à une ligne de rangée Ri destinée à sélectionner tous les transistors Pij d'une même rangée. Ainsi, dans une première phase, on précharge les diodes Dij. Ensuite, après éclairement, on lit la tension aux bornes des diodes au moyen d'un amplificateur constitué par exemple d'un premier transistor Tij dont la grille est reliée au point de connexion du transistor Pij de la diode Dij, dont la source est reliée à une ligne de colonne Cj et dont le drain est relié à une tension haute Vdd. Chaque ligne Cj est reliée à un amplificateur Aj formant par exemple avec le transistor Tij un amplificateur suiveur.

Dans une telle structure, chaque diode Dij peut être du type décrit précédemment, c'est-à-dire être associée à un condensateur en parallèle Cij.

Un exemple de réalisation de l'association d'un transistor de précharge Pij et d'une diode Dij est illustré en figure 4. Cette structure est formée dans un substrat de silicium monocristallin 10 de type P. Chaque transistor Pij comprend une région de drain 11 de type N et une région de source 12 également de type N. La région de source 12 s'étend pour constituer la région de cathode de la diode Dij dont l'anode correspond au substrat 10. Entre le drain et la source du transistor Pij est formée une grille isolée 13, par exemple en silicium polycristallin. Au-dessus de la plus grande partie de la région 12, on retrouve la structure de filtre interférentiel comprenant les couches 4, 5 et 6 déjà décrites en relation avec la figure 1. La région de drain 11 est solidaire d'une métallisation 15 établissant un contact avec une source de tension de précharge VR.

La région de source/cathode 12 est solidaire d'une métallisation 16 reliée à la grille du transistor Tij (voir figure 3). En outre, et selon l'invention, la région de silicium polycristallin 5 est reliée au substrat 10. Plus couramment, chacune de ces régions sera reliée à une masse commune.

Selon une variante de la présente invention, les diodes peuvent être formées dans un caisson lui-même formé dans un substrat, c'est-à-dire, en considérant la figure 4, que la région P 10 est un caisson formé dans un substrat de type N non représenté. Dans ce cas la région de silicium polycristallin 5 pourra être reliée au substrat et non directement à la région 10.

Bien entendu, la présente invention est susceptible de diverses variantes et modifications qui apparaîtront à l'homme de l'art. Notamment, les divers matériaux décrits pourront être remplacés par des matériaux équivalents. D'autres matériaux compatibles avec la fabrication de composants semiconducteurs pourront être utilisés pour réaliser le filtre interférentiel formé au-dessus de chaque diode. La caractéristique essentielle de l'invention est que l'une des couches de ce filtre interférentiel, séparée du substrat semiconducteur par une couche isolante, est conductrice et est connectée à ce substrat. Tous les types de conductivité décrits pourront être inversés. De plus, bien que l'on ait décrit un substrat de silicium, on notera que d'autres systèmes semiconducteurs pourront être adaptés à la mise en oeuvre de l'invention.

## Revendications

1. Réseau de photodiodes constitué de régions d'un deuxième type de conductivité (1 ; 12) formées dans une région semiconductrice d'un premier type de conductivité (2 ; 10), divisé en trois sous-réseaux imbriqués, toutes les photodiodes d'un même sous-réseau étant revêtues d'un même filtre interférentiel comprenant au moins une couche isolante (4) d'épaisseur déterminée revêtue d'au moins une couche conductrice (5), **caractérisé en ce que** lesdites couches conductrices sont électriquement connectées à la région semiconductrice d'un premier type de conductivité (2 ; 10).

2. Réseau de photodiodes selon la revendication 1, dans lequel lesdites couches conductrices et la région semiconductrice sont connectées à un même potentiel.

3. Réseau de photodiodes selon la revendication 1, dans lequel le substrat semiconducteur est un substrat de silicium monocristallin, **caractérisé en ce que** le filtre interférentiel comporte une couche d'oxyde de silicium (4) formée au-dessus du substrat et une couche de silicium polycristallin conducteur (5) formée au-dessus de la couche d'oxyde de silicium.

## Claims

1. An array of photodiodes made of regions of a second conductivity type (1; 12) formed in a semiconductive region of a first conductivity type (2; 10), divided into three interleaved sub-arrays, all the photodiodes of a same sub-array being coated with a same interference filter including at least one insulating layer (4) of determined thickness coated with at least one conductive layer (5), **characterized in that** said conductive layers are electrically connected to the semiconductive region of a first conductivity type (2; 10).

2. The array of photodiodes of claim 1, wherein said conductive layers and said semiconductive layer are connected to a same potential.

3. The array of photodiodes of claim 1, wherein the semiconductor substrate is a single-crystal silicon substrate, and the interference filter includes a silicon oxide layer (4) formed above the substrate and a conductive polysilicon layer (5) formed above the silicon oxide layer.

## Patentansprüche

1. Eine Anordnung von Fotodioden, die aus Bereichen eines zweiten Leitfähigkeitstyps (1; 12) hergestellt und in einem Halbleiterbereich eines ersten Leitfähigkeitstyps (2; 10) ausgebildet sind, und die in drei verschachtelte Subanordnungen unterteilt sind, wobei alle Fotodioden derselben Subanordnung mit einem gleichen Interferenzfilter beschichtet sind, der wenigstens eine isolierende Schicht (4) mit vorbestimmter Dicke umfasst, der mit wenigstens einer leitenden Schicht (5) beschichtet ist, **dadurch gekennzeichnet, dass** die leitenden Schichten elektrisch mit dem Halbleiterbereich des ersten Leitfähigkeitstyps (2; 10) verbunden sind.

2. Anordnung von Fotodioden nach Anspruch 1, wobei die leitenden Schichten und die Halbleiterschicht mit demselben Potential verbunden sind.

3. Anordnung von Fotodioden nach Anspruch 1, wobei das Halbleitersubstrat ein Einkristall-Silizium-Substrat ist und der Interferenzfilter eine Siliziumoxidschicht (4) umfasst, die oberhalb des Substrats ausgebildet ist und eine leitende Polysiliziumschicht (5) umfasst, die oberhalb der Siliziumoxidschicht ausgebildet ist.
